# FASCICULE DE BREVET EUROPEEN

(11) **EP 1 240 672 B1**
(45) Date de publication et mention de la délivrance du brevet: **14.06.2006**
(21) Numéro de dépôt: 00993557.8
(22) Date de dépôt: 21.12.2000
(51) Int. Cl.: H01L 29/78, H01L 29/872

(54) **Production de composants unipolaires**
Herstellung von unipolaren Komponenten
Production of single-pole components

(30) Priorité: 22.12.1999 FR 9916291
(43) Date de publication de la demande: 18.09.2002
(73) Titulaire: STMicroelectronics S.A., 92120 Montrouge (FR)
(72) Inventeur: LANOIS, Frédéric, F-37100 Tours (FR)
(74) Mandataire: de Beaumont, Michel
(86) Numéro de dépôt international: PCT/FR2000/003655
(87) Numéro de publication internationale: WO 2001/047028

(56) Documents cités:
- EP-A- 0 506 450
- WO-A-99/26296
- DE-A- 19 631 872
- DE-C- 19 815 907
- FR-A- 2 361 750
- US-A- 5 430 323
- PATENT ABSTRACTS OF JAPAN vol. 007, no. 027 (E-156), 3 février 1983 (1983-02-03) & JP 57 181172 A (TOKYO SHIBAURA DENKI KK), 8 novembre 1982 (1982-11-08)

## Description

La présente invention concerne la fabrication de composants unipolaires sous forme monolithique verticale. La description suivante vise plus particulièrement, uniquement à titre d'exemple, le cas de composants de type diode Schottky réalisés sous forme verticale dans des substrats de silicium.

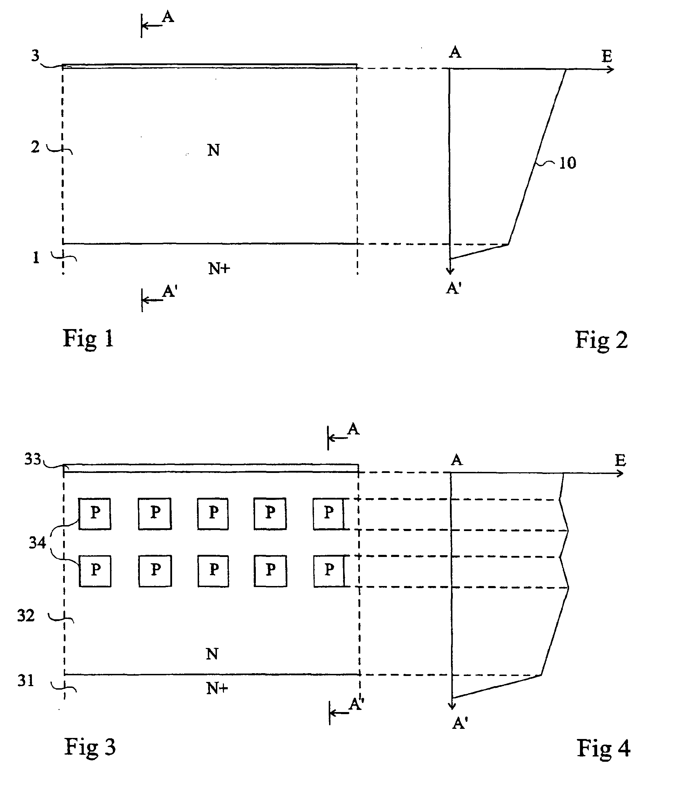

La figure 1 illustre une structure classique de diode Schottky. Une telle structure comporte un substrat semiconducteur 1, typiquement en silicium monocristallin, fortement dopé d'un premier type de conductivité, généralement de type N. Une couche de cathode 2 recouvre le substrat 1. Elle est dopée de type N, mais plus faiblement que le substrat 1. Une couche métallique 3 forme un contact Schottky avec la cathode 2 de type N.

L'épaisseur de la couche 2 est choisie pour assurer la tenue en tension en polarisation inverse (tension de claquage) de la diode Schottky.

La figure 2 illustre le profil de variation du champ électrique E dans l'épaisseur de la structure représentée en figure 1, selon un axe A-A'. Par souci de clarté, on a fait correspondre, par des traits en pointillés, les différentes parties de la courbe 10 de la figure 2 aux régions correspondantes de la figure 1.

Dans une telle structure homogène, la variation du champ par unité d'épaisseur est proportionnelle au niveau de dopage. En d'autres termes, le champ décroît d'autant plus rapidement que le dopage est élevé. Il chute donc très rapidement à une valeur nulle dans le substrat 1. La tenue en tension correspondant à la surface comprise entre les axes et la courbe 10, il faut, pour obtenir une tension de claquage élevée, minimiser le dopage de la couche 2 et maximiser son épaisseur.

Lors de la fabrication de composants unipolaires, il faut alors concilier des contraintes opposées. En effet, les composants unipolaires, tels que la diode représentée en figure 1, doivent présenter une résistance la plus petite possible quand ils sont à l'état passant (Ron), tout en ayant une tension de claquage la plus élevée possible quand ils sont polarisés en inverse. Minimiser la résistance à l'état passant d'un composant unipolaire impose de minimiser l'épaisseur de la couche la moins dopée (la couche 2) et de maximiser le dopage de cette couche.

Pour optimiser la tension de claquage sans modifier la résistance Ron, on a proposé des structures du type de celle de la figure 3. En figure 3 une diode Schottky verticale comporte un substrat semiconducteur 31 en silicium monocristallin, fortement dopé d'un premier type de conductivité, typiquement de type N, recouvert d'une couche 32. La couche 32 est constituée du même matériau semiconducteur que le substrat 31 et est de même type de dopage que celui-ci, mais plus faiblement dopée. La couche 32 est destinée à constituer la cathode de la diode Schottky. Une couche métallique 33 recouvre la couche 32. Le métal constituant la couche 33 est choisi pour constituer un contact Schottky avec le silicium 32 de type N.

La couche 32 comporte des régions ou "îlots" de silicium 34 très fortement dopés de type P. Les îlots 34 sont répartis sur au moins un niveau horizontal (sur deux niveaux dans l'exemple de la figure 3).

Les îlots 34 sont disjoints et noyés dans la couche 32. Les îlots 34 de niveaux horizontaux différents sont répartis sensiblement sur de mêmes lignes verticales.

La figure 4 illustre le profil de variation du champ électrique E dans l'épaisseur d'une structure similaire à celle de la figure 3. Plus particulièrement, le profil de la figure 4 est observé selon l'axe A-A' de la figure 3.

Comme cela ressort de la comparaison des figures 2 et 4, l'insertion des "îlots" 34 fortement dopés de type P dans la structure de la figure 3 modifie la variation du champ E par unité d'épaisseur. Comme les îlots 34 sont nettement plus dopés que la couche 32 de type N, il y a plus de charges négatives créées dans les îlots 34 que de charges positives dans la couche 2. Le champ réaugmente donc dans chacune des zones horizontales comportant les îlots 34. En réglant le dopage et le nombre des îlots 34, on peut élargir quasi indéfiniment la zone de la charge d'espace. En polarisation inverse, la cathode constituée de la couche 32 et des îlots 34 se comporte alors globalement comme une couche quasi-intrinsèque. En moyenne, la variation du champ électrique par unité d'épaisseur diminue donc fortement. Alors, pour un niveau de dopage donné de la couche 32, la tenue en tension est améliorée, comme l'illustre l'augmentation de la surface délimitée par les axes et la courbe de la figure 4 par rapport à la surface correspondante de la figure 2.

Par conséquent, la structure de la figure 3 permet d'obtenir des composants unipolaires de tenue en tension (tension de claquage) donnée à résistance Ron inférieure à celle d'une structure classique.

La réalisation pratique d'une telle structure à îlots est décrite, par exemple, dans le brevet allemand 19815907 délivré le 27 mai 1999 (correspondant au préambule de la revendication 1), dans les demandes de brevet DE 19631872 et WO99/26296 et dans le brevet français 2361750 délivré le 10 mars 1978. Ces différents documents proposent d'obtenir une structure similaire à celle de la figure 3 par la mise en oeuvre d'implantation/diffusion au cours d'une épitaxie de croissance de la couche 32.

Un inconvénient d'une telle réalisation réside dans les interruptions répétées de la croissance épitaxiale. En effet, la couche épaisse 32 ainsi obtenue présente une structure irrégulière. De telles irrégularités de structure altèrent les performances du composant final.

Un objet de la présente invention est de proposer un nouveau procédé de fabrication de composants unipolaires de type vertical de tenue en tension déterminée qui présente une résistance à l'état passant réduite. La présente invention vise également les composants obtenus.

Pour atteindre ces objets, la présente invention prévoit un composant unipolaire de type vertical selon la revendication 1.

Selon un mode de réalisation de la présente invention, le composant comporte au moins deux niveaux, les régions indépendantes de niveaux successifs étant sensiblement alignées verticalement.

Selon un mode de réalisation de la présente invention, les régions indépendantes sont des anneaux.

Selon un mode de réalisation de la présente invention, le niveau le plus profond comporte des régions non annulaires.

La présente invention prévoit également un procédé de fabrication d'un composant unipolaire de type vertical dans un substrat de silicium d'un type de conductivité donné, comprenant les étapes suivantes :
a) former, dans une couche épaisse de silicium recouvrant le substrat, dopée du même type de conductivité que celui-ci mais plus faiblement, des ouvertures ;
b) revêtir les parois et les fonds des ouvertures d'une couche d'oxyde de silicium ;
c) former, par implantation/diffusion à travers les fonds des ouvertures, des régions du type de conductivité opposé à celui du substrat ; et
d) remplir les ouvertures d'un matériau isolant.

Selon un mode de réalisation de la présente invention, avant l'étape d) de remplissage des ouvertures, les étapes a) à c) sont répétées au moins une fois, les ouvertures initiales étant prolongées dans la couche épaisse de silicium.

Selon un mode de réalisation de la présente invention, la couche de silicium du même type de conductivité donné que le substrat est destinée à constituer la cathode d'une diode Schottky.

Selon un mode de réalisation de la présente invention, la couche de silicium du même type de conductivité que le substrat est destinée à constituer le drain d'un transistor MOS.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 illustre, en vue en coupe partielle et schématique, une structure classique de diode Schottky ;
la figure 2 illustre la variation du champ électrique dans l'épaisseur de la structure de la figure 1 ;
la figure 3 illustre, en vue en coupe partielle et schématique, la structure d'une diode Schottky de tenue en tension déterminée à résistance à l'état passant réduite ;
la figure 4 illustre la variation du champ électrique dans l'épaisseur de la structure de la figure 3 ; et
les figures 5A à 5D sont des vues en coupe partielles et schématiques d'une diode Schottky à différentes étapes d'un procédé de fabrication selon la présente invention.

Par souci de clarté, les mêmes éléments ont été désignés par les mêmes références aux différentes figures. De plus, comme cela est habituel dans la représentation des circuits intégrés, les figures ne sont pas tracées à l'échelle.

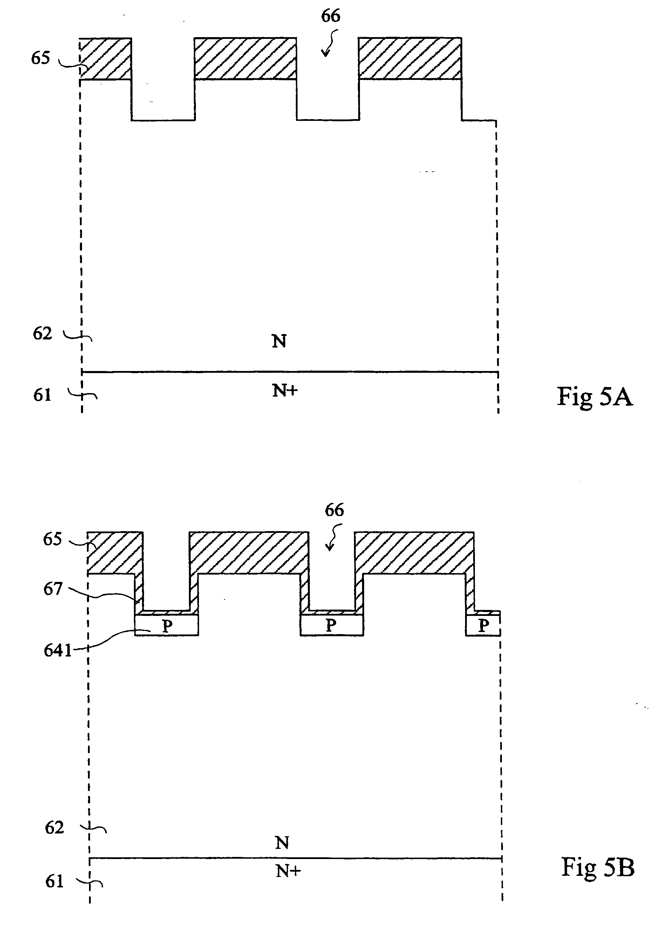

Les figures 5A à 5D illustrent des étapes d'un procédé de fabrication d'une diode Schottky monolithique verticale selon l'invention.

Comme l'illustre la figure 5A, un substrat 61 est initialement recouvert d'une couche 62 de silicium monocristallin, du même type de dopage, par exemple N, que le substrat 61. La couche 62, destinée à constituer la cathode de la diode Schottky, est plus faiblement dopée que le substrat 61. La couche 62 est gravée, à l'aide d'un masque 65, de façon à former des ouvertures 66. Le substrat 61 et la couche 62 sont obtenus par tout procédé approprié. Par exemple, la couche 62 peut résulter d'une croissance épitaxiale sur le substrat 61, ou le substrat 61 et la couche 62 peuvent être initialement une même région semiconductrice, les différences de dopage résultant alors d'opérations d'implantation-diffusion.

Aux étapes suivantes, illustrées en figure 5B, on forme sur les parois et au fond des ouvertures 66 une couche isolante 67, par exemple, une couche d'oxyde de silicium (SiO₂). Ensuite, on implante verticalement un dopant de type P qui pénètre dans le silicium au fond des ouvertures 66, puis on chauffe pour former des régions diffusées 641 fortement dopées de type P.

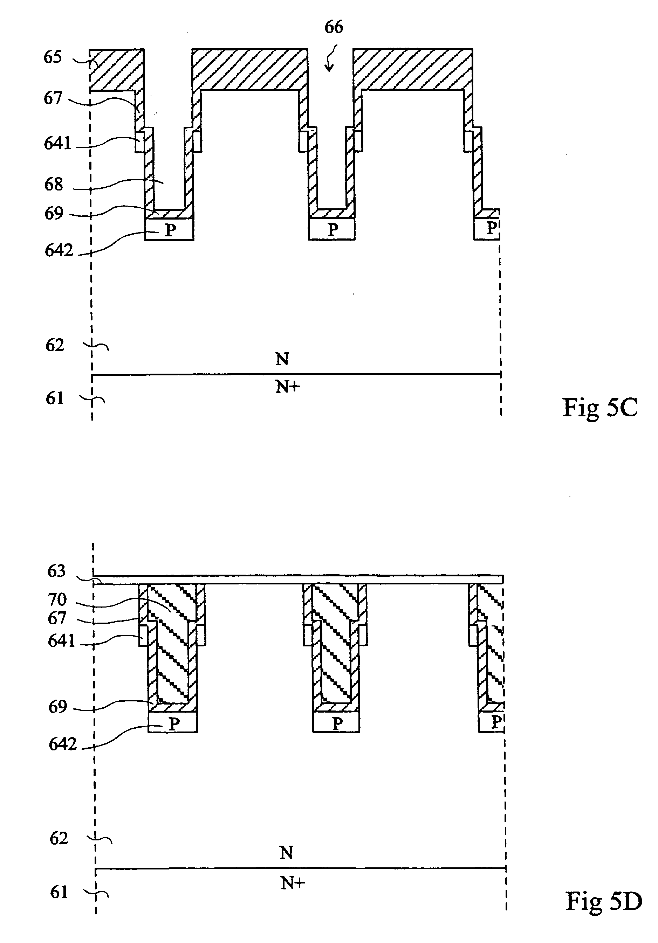

Aux étapes suivantes, illustrées en figure 5C, on procède à une gravure anisotrope de la couche 67, des régions 641 et de la couche 62 pour former des ouvertures 68 qui prolongent les ouvertures 66. La partie supérieure de chacune des ouvertures 68 est donc entourée d'un anneau diffusé 641. Ensuite, les parois et les fonds des ouvertures 68 sont recouverts d'une couche isolante mince 69, par exemple de l'oxyde de silicium.

On répète alors les opérations d'implantation décrites précédemment en relation avec la figure 5B de façon à former des régions 642 fortement dopées de type P.

Aux étapes suivantes, illustrées en figure 5D, les ouvertures 66-68 sont remplies d'un matériau isolant 70. Ensuite, le masque 65 est éliminé et la structure ainsi obtenue est planarisée. Enfin, on dépose sur toute la structure une couche métallique 63 propre à assurer un contact Schottky avec la couche 62.

Avant d'achever, conformément aux étapes décrites en relation avec la figure 5D, la formation de la structure par l'enlèvement du masque 65, le remplissage des ouvertures 66-68 par le matériau 70 et le dépôt d'une couche métallique 63, on pourrait répéter à plusieurs reprises les étapes décrites en relation avec la figure 5C, de façon à former plusieurs niveaux horizontaux d'anneaux fortement dopés de type P similaires aux anneaux 641.

On notera que les anneaux intermédiaires et les régions sous-jacentes constituent des îlots selon la définition précédente. Ils assurent donc les avantages correspondants, exposés précédemment en relation avec les figures 3 et 4.

Un avantage du procédé selon l'invention et de la structure résultante, décrite précédemment en relation avec la figure 5D, réside dans la formation d'une région de cathode 62 homogène.

L'homme de l'art saura adapter le nombre, les dimensions, les positions et le dopage des différents anneaux 641, 642 aux performances recherchées. A titre d'exemple, selon l'art antérieur, pour obtenir une tenue en tension d'environ 600 volts, on peut utiliser une couche de cathode (2, figure 1) d'une épaisseur d'approximativement 40 µm et d'un niveau de dopage de l'ordre de 2,2.10¹⁴ atomes/cm³, d'où il résulte une résistance à l'état passant d'environ 6,7 Ω.mm². Selon l'invention, en utilisant des groupes de trois anneaux dopés de type P à environ 3,5.10¹⁷ atomes/cm³, espacés verticalement de 10 µm les uns des autres autour de colonnes d'oxyde de silicium de 1 µm de largeur, pour une même tenue en tension de 600 V avec une couche épitaxiée (62, figure 5D) d'une même épaisseur de l'ordre de 40 µm, le dopage de la cathode pourrait être augmenté à une valeur de l'ordre de quelques 10¹⁵ atomes/cm³, d'où il résulte une résistance à l'état passant d'environ 3 Ω.mm².

On notera que l'on a choisi de décrire à titre d'exemple non-limitatif la présente invention en relation avec la figure 6 appliquée à la formation d'îlots de silicium dans la cathode d'une diode Schottky. Il serait toutefois possible de mettre en oeuvre un procédé visant à former dans le drain d'un transistor MOS, autour de colonnes verticales d'un matériau isolant, des anneaux de silicium très fortement dopés de type P, de façon similaire au procédé décrit précédemment en relation avec les figures 5A-D.

Bien entendu, la présente invention est susceptible de diverses variantes et modifications qui apparaîtront à l'homme de l'art. En particulier, les opérations décrites en relation avec la figure 5D peuvent être réalisées selon toute séquence appropriée. Ainsi, après le remplissage des ouvertures 66-68, on pourra éliminer la couche 65 et effectuer la planarisation de la structure en une seule et même étape à l'aide d'un procédé de planarisation mécano-chimique (CMP).

En outre, la présente invention s'applique à la réalisation sous forme verticale de tout type de composant unipolaire que ce soit pour réduire sa résistance à l'état passant pour une tenue en tension donnée, ou pour améliorer sa tenue en tension sans augmenter sa résistance à l'état passant.

## Revendications

1. Composant unipolaire de type vertical comportant des régions (641, 642) d'un premier type de conductivité (P) noyées dans une couche épaisse (62) d'un deuxième type de conductivité (N), lesdites régions étant réparties sur au moins un même niveau horizontal et étant indépendantes les unes des autres, **caractérisé en ce que** lesdites régions indépendantes noyées sont sous-jacentes à, ou entourent, des colonnes remplies d'au moins un matériau isolant (70).

2. Composant selon la revendication 1, **caractérisé en ce qu'**il comporte au moins deux niveaux, les régions indépendantes (641, 642) de niveaux successifs étant sensiblement alignées verticalement.

3. Composant selon la revendication 2, **caractérisé en ce que** les régions indépendantes (641) sont des anneaux entourant lesdites colonnes.

4. Composant selon la revendication 3, **caractérisé en ce que** le niveau le plus profond comporte des régions (642) non annulaires.

5. Procédé de fabrication d'un composant unipolaire de type vertical dans un substrat de silicium (61) d'un type de conductivité donné (N), comprenant les étapes suivantes :
a) former, dans une couche épaisse de silicium (62) recouvrant le substrat, dopée du même type de conductivité donné que celui-ci mais plus faiblement, des ouvertures (66) ;
b) revêtir les parois et les fonds des ouvertures d'une couche d'oxyde de silicium (67);
c) former, par implantation/diffusion à travers les fonds des ouvertures, des régions (641) du type de conductivité opposé (P) à celui du substrat ; et
d) remplir les ouvertures d'un matériau isolant (70).

6. Procédé selon la revendication 5, **caractérisé en ce que**, avant l'étape d) de remplissage des ouvertures (66, 68), les étapes a) à c) sont répétées au moins une fois, les ouvertures initiales étant prolongées dans la couche épaisse de silicium (62).

7. Procédé selon la revendication 5 ou 6, **caractérisé en ce que** la couche de silicium (62) du même type de conductivité donné (N) que le substrat (61) est destinée à constituer la cathode d'une diode Schottky.

8. Procédé selon la revendication 5 ou 6, **caractérisé en ce que** la couche de silicium du même type de conductivité (N) que le substrat est destinée à constituer le drain d'un transistor MOS.

## Claims

1. A single-pole component of vertical type, including regions (641, 642) of a first conductivity type (P) buried in a thick layer (62) of a second conductivity type (N), said regions being distributed over at least one same horizontal level and being independent from one another, **characterized in that** said independent buried regions are under or around columns filled with an insulating material (70).

2. The component of claim 1, **characterized in that** it includes at least two levels, the independent regions (641, 642) of successive levels being substantially vertically aligned.

3. The component of claim 2, **characterized in that** the independent regions (641) are rings surrounding said columns.

4. The component of claim 3, **characterized in that** the deepest level includes non ring-shaped regions (642).

5. A method of manufacturing a single-pole component of vertical type in a silicon substrate (61) of a determined conductivity type (N), **characterized in that** it includes the steps of:
a) forming openings (66) in a thick silicon layer (62) covering the substrate, doped of the same conductivity type as said substrate, but more lightly;
b) coating the walls and bottoms of the openings with a silicon oxide layer (67);
c) forming, by implantation/diffusion through the opening bottoms, regions (641) of the conductivity type opposite (P) to that of the substrate; and
d) filling the openings with an insulating material (70).

6. The method of claim 5, **characterized in that**, before step d) of filling the openings (66, 68), steps a) to c) are repeated at least once, the initial openings being continued into the thick silicon layer (62).

7. The method of claim 5 or 6, **characterized in that** the silicon layer (62) of the same given type of conductivity (N) as the substrate (61) is intended for forming the cathode of a Schottky diode.

8. The method of claim 5 or 6, **characterized in that** the silicon layer of same conductivity type (N) as the substrate is intended for forming the drain of a MOS transistor.

## Patentansprüche

1. Unipolare Komponente des vertikalen Typs, mit Bereichen (641, 642) eines ersten Leitungstyps (P), die in einer dicken Schicht (62) eines zweiten Leitungstyps (N) eingebettet sind, wobei die Bereiche auf ziurnindest einer gemeinsamen horizontalen Ebene geteilt und voneinander unabhängig sind, **dadurch gekennzeichnet, daß** die unabhängigen eingebetteten Bereiche unterhalb von Säulen vorgesehen sind oder diese umgeben, wobei diese zumindest rrait einenn isolierenden Material (70) gefüllt sind.

2. Komponente nach Anspruch 1, wobei diese mindestens zwei Ebenen umfaßt, wobei die unabhängigen Bereiche (641, 642) aufeinanderfolgender Ebenen im wesentlichen vertikal ausgerichtet sind.

3. Komponente nach Anspruch 2, wobei die unabhängigen Bereiche (641) Ringe sind, welche die Säulen umgeben.

4. Komponente nach Anspruch 3, wobei die unterste Ebene nicht-kreisrormige Bereiche (642) umfaßt.

5. Verfahren zur Herstellung einer unipolaren Komponente des vertikalen Typs in einem Siliziumsubstrat (61) eines vorgegebenen Leitungstyps (N), welches die folgenden Schritte umfaßt:
a) Ausbilden von Öffnungen (66) in einer dicken Siliziumschicht (62), welche das Substrat überdeckt, und die mit dem gleichen vorgegebenen Leitungstyp, jedoch in geringerem Maße, dotiert ist;
b) Auskleiden der Wände und der Böden der Öffnungen einer Siliziumoxidschicht (67);
c) Ausbilden von Bereichen (641) mit einexn Leitungstyp (P), der dem des Substrats entgegengesetzt ist, mittels Implantierung/Diffusion durch die Böden der Öffnungen hindurch; und
d) Ausfüllen der Öffnungen mit einexn isolierenden Material (70)

6. Verfahren nach Anspruch 5, wobei vor dem Schritt d) des Ausfüllens der Öffnungen (66, 68) die Schritte a) bis c) mindestens einmal wiederholt werden, und die anfänglichen Öffnungen in die dicke Siliziumschicht (62) hinein verlängert werden.

7. Verfahren nach Anspruch 5 oder 6, wobei die Siliziumschicht (62), die den gleichen vorgegebenen Leitungstyps (N), wie das Substrat (61) aufweist, vorgesehen ist, die Kathode einer Schottky-Diode zu bilden.

8. Verfahren nach Anspruch 5 oder 6, wobei die Siliziumschicht, die den gleichen Leitungstyp (N) wie das Substrat aufweist, vorgesehen ist, den Drain eines MOS-Transistors zu bilden.
